# EUROPEAN PATENT SPECIFICATION

(11) **EP 4 312 338 B1**
(45) Date of publication and mention of the grant of the patent: **17.09.2025**
(21) Application number: 22216746.2
(22) Date of filing: 27.12.2022
(51) Int. Cl.: H02J 7/00

(54) **BATTERY PACK, ELECTRIC TOOL AND CHARGING DEVICE**
BATTERIEPACK, ELEKTROWERKZEUG UND LADEVORRICHTUNG
BLOC-BATTERIE, OUTIL ÉLECTRIQUE ET DISPOSITIF DE CHARGE

(30) Priority: 29.07.2022 CN 202222028057 U; 30.09.2022 CN 202211208000
(43) Date of publication of application: 31.01.2024
(73) Proprietor: Ningbo Daye Garden Machinery Co., Ltd., 315403 Yuyao Zhejiang (CN)
(72) Inventor: Wu, Wenming, Yuyao 315403 (CN); Chen, Huaide, Yuyao 315403 (CN); Peng, Lijun, Yuyao 315403 (CN); Yang, Yunbo, Yuyao 315403 (CN); Ding, Qian, Yuyao 315403 (CN); Xiaobo Ye, Yuyao, Zhejiang/315403 (CN)
(74) Representative: Lang, Christian

(56) References cited:
- WO-A1-2022/028399
- CN-A- 109 245 237
- CN-A- 111 816 819
- KR-B1- 101 680 189
- US-A1- 2020 127 339
- US-B2- 10 177 701
- US-B2- 11 211 664

## Description

### BACKGROUND

### Technical Field

The present disclosure relates to a field of a battery pack, and more particularly to a battery pack, electric tools with battery packs, and charging device applied with battery packs.

### Related Art

Electric tools are gradually driven by storage batteries using secondary batteries such as lithium-ion batteries. Storage batteries are each configured to be detachable from an electric tool body. If a voltage drops due to discharge, the storage battery is removed from the electric tool body and charged by an external charging device. Different types of electric tools often have different requirements for voltage and current, and a battery pack with a single voltage cannot supply power for different types of electric tools. Battery packs with different voltage platforms need to be designed to meet requirements of electric tools with different voltages.

For a user, when electric tools with two voltages are used, matching storage batteries/battery packs are required. For some high-power electric tools, power consumption is very fast. Therefore, it is required to prepare more corresponding battery packs, which increases a burden on the user virtually.

Document US 2020/0127339 A1 discloses a battery pack and electrical device using the battery pack, wherein series connections of the battery cell groups for realizing a multi-voltage pack are realized directly inside the device.

However, existing battery packs need to be improved to broaden application scenarios thereof.

### SUMMARY

A number of embodiments of the present disclosure are described herein in summary.

However, the vocabulary expression of the present disclosure is only used to describe some embodiments (whether or not already in the claims) disclosed in this specification, rather than a complete description of all possible embodiments. Some embodiments described above as various features or aspects of the present disclosure may be combined in different ways to form a battery pack or a portion thereof.

In order to solve the problems existing in the prior art, the present disclosure provides a battery pack having the features of claim 1, an electric tool with battery packs having the features of claim 9, and a charging device applied with battery packs having the features of claim 10. Further embodiments of the battery pack according to the disclosure are subject matter of the dependent claims. The battery pack according to the disclosure externally outputs a voltage by matching an external connecting terminal without using a step-up/step-down voltage conversion circuit. The battery pack comprising a housing having a connecting portion configured to match and connect to a tool or a charging device, wherein the connecting portion comprises a first connecting terminal, a second connecting terminal, a third connecting terminal, a fourth connecting terminal, a fifth connecting terminal, and a sixth connecting terminal; a first battery cell group and a second battery cell group are disposed in the housing, and a quantity of battery cells electrically connected in series in the first battery cell group is equal to a quantity of battery cells electrically connected in series in the second battery cell group; wherein the first battery cell group has a first positive terminal and a first negative terminal, and the second battery cell group has a second positive terminal and a second negative terminal; wherein the first positive terminal, the first negative terminal, the second positive terminal and the second negative terminal match and correspondingly connect to the second connecting terminal to the fifth connecting terminal, respectively; wherein the sixth connecting terminal functioning as a signal terminal is electrically connected to a control module disposed in the housing; and wherein the first connecting terminal functioning as a charging terminal is electrically connected to a first end of a switch, a second end of the switch is electrically connected to the first positive terminal, and a third end of the switch is electrically connected to the control module.

Preferably, a quantity of battery cells in the first battery cell group and the second battery cell group is greater than or equal to 1, respectively.

Preferably, the switch is an electrically controlled switch.

Preferably, the electrically controlled switch is one of an MOSFET, an IGBT, a relay, a silicon-controlled rectifier, a transistor, or a thyristor.

Preferably, the connecting portion is integrally formed with a part of the housing.

Preferably, the battery pack further comprises a mounting portion disposed on a side of the battery pack, the connecting portion is arranged on a side of the mounting portion, and the mounting portion is configured to match and connect to the tool or the charging device.

Preferably, the battery pack further comprises a display portion disposed on the housing, wherein the display portion is electrically connected to the control module, which triggers the display portion to display an electric quantity of the first battery cell group and/or the second battery cell group.

Preferably, the battery pack further comprises a trigger button arranged on the housing and electrically connected to the control module, wherein the display portion displays the electric quantity of the first battery cell group and/or the second battery cell group when the trigger button is pressed.

In order to solve the problems existing in the prior art, the present disclosure further provides a charging device for charging the battery pack. The charging device comprises external corresponding terminals matching the connecting terminals respectively, and two of the external corresponding terminals are configured to be electrically connected to the second positive terminal and the first negative terminal respectively, and electrically connect the second positive terminal to the first negative terminal, or
two of the external corresponding terminals are configured to be electrically connected to the first positive terminal and the second positive terminal respectively, and electrically connect the first positive terminal to the second positive terminal, the other two of the external corresponding terminals are configured to be electrically connected to the first negative terminal and the second negative terminal respectively, and electrically connect the first negative terminal to the second negative terminal.

In order to solve the problems existing in the prior art, the present disclosure further provides an electric tool carrying the battery pack. The electric tool performs discharge control on the battery pack.

Compared with the prior art, the battery pack of the present disclosure can externally output two voltages by changing input/output connection lines matching the six connecting terminals.

The advantages of the present disclosure can be understood further by the following invention descriptions and attached drawings.

### BRIEF DESCRIPTION OF THE DRAWINGS

In order to more clearly explain the embodiment of the present disclosure or the technical scheme in the prior art, the following will briefly introduce the attached drawings that need to be used in the embodiment. It is obvious that the attached drawings in the following description are only some embodiments of the present disclosure. For ordinary technicians in the art, without paying creative labor, other drawings can also be obtained from these drawings.
FIG. 1 illustrates a schematic diagram of a topological structure of a battery pack according to an embodiment of the present disclosure.
FIG. 2 illustrates a schematic diagram of a topological structure of five battery cells in a battery cell group in a battery pack according to an embodiment of the present disclosure.
FIG. 3 illustrates a schematic diagram of a topological structure of four battery cells in a battery cell group in a battery pack according to an embodiment of the present disclosure.
FIG. 4 illustrates a schematic diagram of functional topology of connection between a battery pack and a charger according to an embodiment of the present disclosure.
FIG. 5 illustrates a schematic diagram of functional topology of connection between a battery pack and another charger according to an embodiment of the present disclosure.
FIG. 6 illustrates a schematic diagram of functional topology of connection between a battery pack and a tool according to an embodiment of the present disclosure.
FIG. 7 illustrates a schematic diagram of functional topology of connection between a battery pack and another tool according to an embodiment of the present disclosure.
FIG. 8 illustrates a schematic diagram of a topological structure of a battery pack according to another embodiment of the present disclosure.
FIG. 9 illustrates a schematic top structural view of a battery pack according to an embodiment of the present disclosure.

### DETAILED DESCRIPTION

The foregoing solutions are further described below with reference to specific embodiments. It should be understood that these embodiments are used to illustrate the present application and are not used to limit the scope of the present application. Implementation conditions adopted in the embodiments can be further adjusted as conditions of specific manufacturers, and implementation conditions not indicated are usually those in routine experiments.

The present disclosure provides a battery pack. The battery pack includes a housing, and a switch, a first battery cell group and a second battery cell group disposed in the housing. The housing includes a connecting portion internally provided with six connecting terminals (a first connecting terminal to a sixth connecting terminal), and a quantity of battery cells sequentially electrically connected in series in the first battery cell group is equal to a quantity of battery cells sequentially electrically connected in series in the second battery cell group, that is, the first battery cell group and the second battery cell group have the same voltage.

The first battery cell group has a first positive terminal and a first negative terminal, and the second battery cell group has a second positive terminal and a second negative terminal.

The first positive terminal, the first negative terminal, the second positive terminal and the second negative terminal respectively match and connect to four connecting terminals in the connecting portion (for example, the first positive terminal, the first negative terminal, the second positive terminal and the second negative terminal respectively match and connect to the second connecting terminal to the fifth connecting terminal).

The sixth connecting terminal functioning as a signal terminal is electrically connected to a control module in the housing.

The first connecting terminal functioning a charging terminal of the battery pack is electrically connected to a first end of the switch, a second end of the switch is electrically connected to the first positive terminal, and a third end (trigger end) of the switch is electrically connected to the control module. If connected to a tool during use, the six connecting terminals of the battery pack are connected by matched external corresponding terminals of connection ends of the tool, and the second connecting terminal 2 is short-circuited with the third connecting terminal 3 and/or the second connecting terminal 2 is short-circuited with the fourth connecting terminal 4, to implement switching of series connection or parallel connection between the first battery cell group and the second battery cell group (without the aid of an electronic conversion circuit, to reduce control complexity and costs), so that the battery pack can externally output two voltages (high voltage/low voltage), thereby meeting voltage requirements of different tools.

Next, the battery pack according to the present disclosure is described with reference to the accompanying drawings.

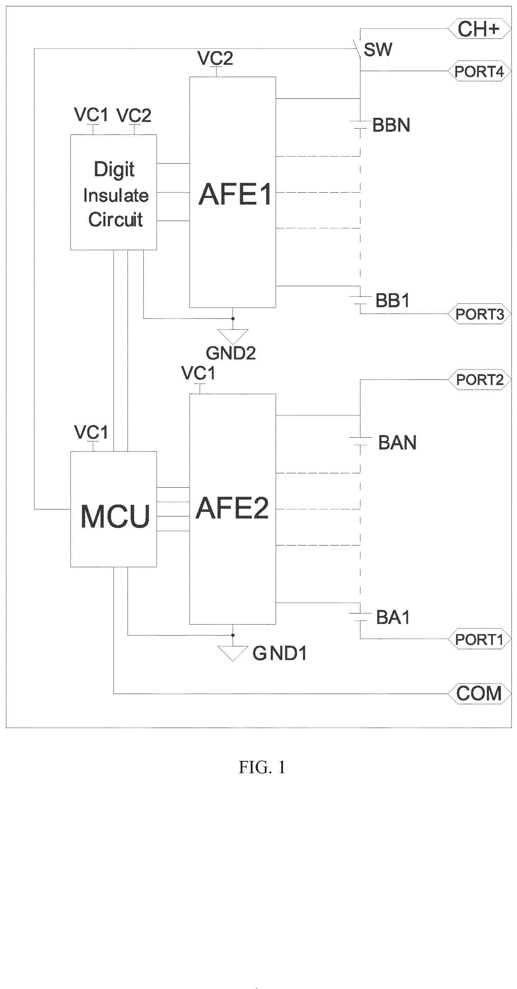

FIG. 1 illustrates a schematic diagram of a topological structure of a battery pack according to an embodiment of the present disclosure.

The battery pack includes a first battery cell group and a second battery cell group, and each battery cell group includes at least one battery cell electrically connected in series.

The first battery cell group has a first positive terminal PORT4 and a first negative terminal PORT3, that is, in the first battery cell group, a negative terminal of a battery cell with a minimum potential is electrically connected to the first negative terminal PORT3, and a positive terminal of a battery cell with a maximum potential is connected to the first positive terminal PORT4.

The second battery cell group has a second positive terminal PORT2 and a second negative terminal PORT1, which match and electrically connect to the connecting portion. That is, in the second battery cell group, a negative terminal of a battery cell with a minimum potential is electrically connected to the second negative terminal PORT1, and a positive terminal of a battery cell with a maximum potential is connected to the second positive terminal PORT2.

A first control unit AFE1 is provided with a plurality of sampling ports, and each sampling port is electrically connected to a matching and corresponding battery cell in the first battery cell group by using a sensor.

A second control unit AFE2 is provided with a plurality of sampling ports, and each sampling port is electrically connected to a matching and corresponding battery cell in the first battery cell group by using a sensor.

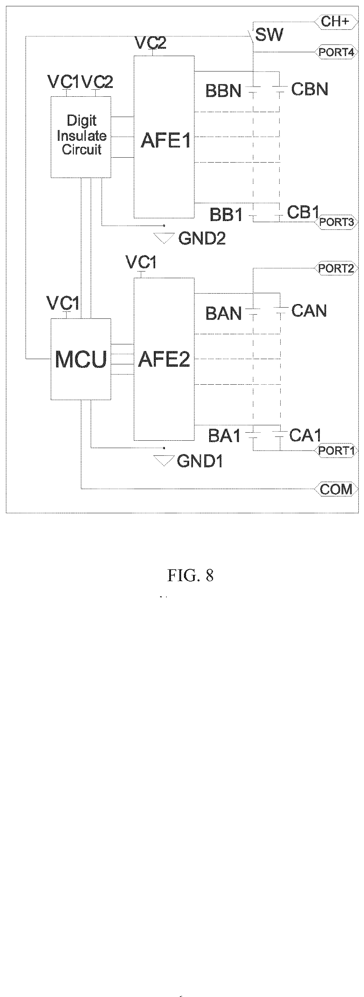

A charging port CH+ electrically connected to the first connecting terminal is electrically connected to a first end of the switch SW, a second end of the switch SW is electrically connected to the first positive terminal, and a third end (trigger end) of the switch SW is electrically connected to a control module MCU. In this embodiment, in each battery cell group, one or more battery cells are provided and are connected in series. The battery cell groups have the same voltage. In some embodiments, each battery cell group may include two branches as shown in FIG. 8. The embodiment shown in FIG. 8 differs from the embodiment shown in FIG. 1 in that each battery cell group may include two branches (also referred to as two branches connected in parallel, where in the first battery cell group, the branch where battery cells BB1 and BBN are located is electrically connected in parallel to the branch where battery cells CB1 and CBN are located; and in the second battery cell group, the branch where battery cells BA1 and BAN are located is electrically connected in parallel to the branch where battery cells CA1 and CAN are located) or more branches connected in parallel, with each branch having one or more battery cells.

Mode 1:
Through insertion of external corresponding terminals (not shown in the figure), a controller of an external charger or a tool short-circuits PORT2 and PORT3, so that the first battery cell group and the second battery cell group are electrically connected in series, and a first voltage for external output or input is obtained between PORT1 and PORT4.

Mode 2:
Through insertion of external corresponding terminals (not shown in the figure), a controller of an external charger or a tool short-circuits PORT2 and PORT4, and short-circuits PORT1 and PORT3, so that a second voltage for external output or input is obtained between PORT4 and PORT1.

In this way, no step-up or step-down conversion circuit or device is disposed in the battery pack, and only by inserting external corresponding terminals (the external corresponding terminals are disposed in the charger or discharge controller) into the connecting terminals disposed on the housing, an open/short circuit change of the two battery cell groups in the battery pack is completed, thereby implementing switching between the first battery cell group and the second battery cell group (series connection or parallel connection) to externally output two voltages.

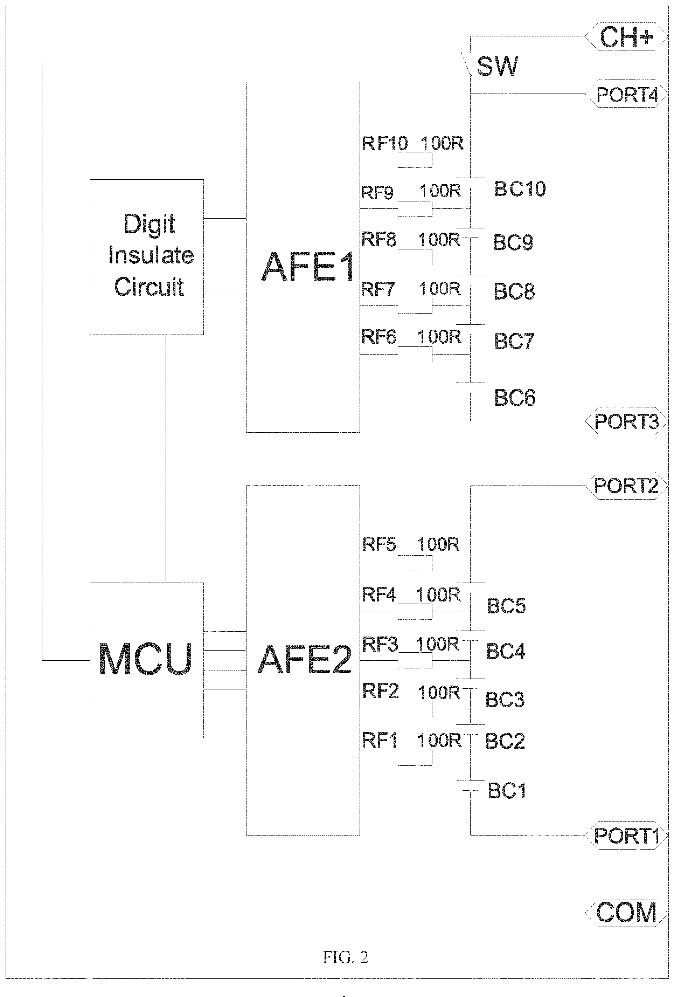

In some embodiments, each battery cell group includes five battery cells electrically connected in series, as shown in FIG. 2. Switching between the first battery cell group and the second battery cell group (series connection or parallel connection) is implemented to externally output two voltages (20 V/40 V).

A first control unit AFE1 is provided with five sampling ports, and each sampling port is electrically connected to a matching and corresponding battery cell in the first battery cell group by using a sensor. For example, one sampling port is electrically connected to a battery cell BC6 by using a sensor RF6, one sampling port is electrically connected to a battery cell BC7 by using a sensor RF7, one sampling port is electrically connected to a battery cell BC8 by using a sensor RF8, one sampling port is electrically connected to a battery cell BC9 by using a sensor RF9, and one sampling port is electrically connected to a battery cell BC10 by using a sensor RF10. The first control unit AFE1 is electrically connected to a control module MCU by using a conversion unit. A negative terminal of the battery cell BC6 is electrically connected to the first negative terminal PORT3, and the battery cell BC10 is electrically connected to the first positive terminal PORT4.

A second control unit AFE2 is provided with five sampling ports, and each sampling port is electrically connected to a matching and corresponding battery cell in the first battery cell group by using a sensor. For example, one sampling port is electrically connected to a battery cell BC1 by using a sensor RF1, one sampling port is electrically connected to a battery cell BC2 by using a sensor RF2, one sampling port is electrically connected to a battery cell BC3 by using a sensor RF3, one sampling port is electrically connected to a battery cell BC4 by using a sensor RF4, and one sampling port is electrically connected to a battery cell BC5 by using a sensor RF5. The second control unit AFE2 is electrically connected to the control module MCU. A negative terminal of the battery cell BC1 is electrically connected to the second negative terminal PORT1, and the battery cell BC5 is electrically connected to the second positive terminal PORT2. In another implementation, each battery cell group may include two or more branches connected in series and parallel, with each branch having five battery cells.

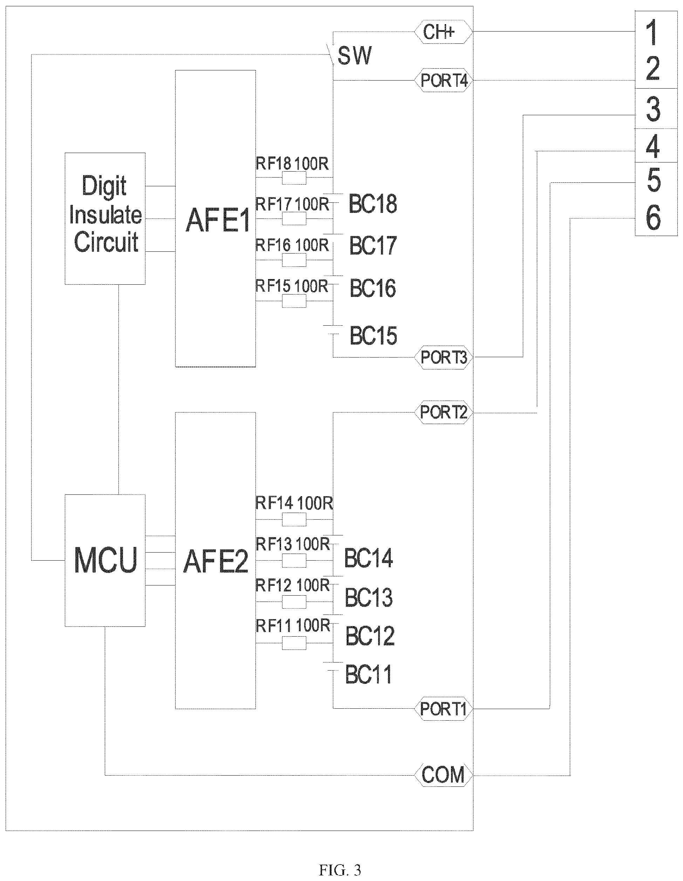

In some embodiments, four battery cells of each battery cell group that may be electrically connected in series are shown in FIG. 3.

The battery pack includes a first battery cell group and a second battery cell group, and each battery cell group includes four battery cells electrically connected in series.

The first battery cell group has a first positive terminal PORT4 and a first negative terminal PORT3. The first positive terminal PORT4 is electrically connected to a second connecting terminal 2 of the connecting portion, and the first negative terminal PORT3 is electrically connected to a third connecting terminal 3 of the connecting portion.

The second battery cell group has a second positive terminal PORT2 and a second negative terminal PORT1. The second positive terminal PORT2 is electrically connected to a fourth connecting terminal 4 of the connecting portion, and the second negative terminal PORT1 is electrically connected to a fifth connecting terminal 5 of the connecting portion.

A first control unit AFE1 includes four sampling ports, and each sampling port is electrically connected to a matching and corresponding battery cell in the first battery cell group by using a sensor. For example, one sampling port is electrically connected to a battery cell BC15 by using a sensor RF15, one sampling port is electrically connected to a battery cell BC16 by using a sensor RF16, one sampling port is electrically connected to a battery cell BC17 by using a sensor RF17, and one sampling port is electrically connected to a battery cell BC18 by using a sensor RF18. The first control unit AFE1 is electrically connected to the control module MCU by using a conversion unit, such as a digit insulate circuit shown in FIG.1 to FIG.3 . A negative terminal of the battery cell BC15 is electrically connected to the first negative terminal PORT3, and a positive terminal of the battery cell BC18 is electrically connected to the first positive terminal PORT4.

A second control unit AFE2 includes four sampling ports, and each sampling port is electrically connected to a matching and corresponding battery cell in the first battery cell group by using a sensor. For example, one sampling port is electrically connected to a battery cell BC11 by using a sensor RF11, one sampling port is electrically connected to a battery cell BC12 by using a sensor RF12, one sampling port is electrically connected to a battery cell BC13 by using a sensor RF13, and one sampling port is electrically connected to a battery cell BC14 by using a sensor RF14. The second control unit AFE2 is electrically connected to the control module MCU through the digit insulate circuit. A negative terminal of the battery cell BC11 is electrically connected to the second negative terminal PORT1, and a positive terminal of the battery cell BC14 is electrically connected to the second positive terminal PORT2.

A charging port CH+ electrically connected to the first connecting terminal 1 is electrically connected to a first end of a switch SW, a second end of the switch SW is electrically connected to the first positive terminal PORT4, and a third end (trigger end) of the switch SW is electrically connected to a control module MCU. The battery pack can externally output two voltages of 16 V/32 V.

Mode 1:
Through insertion of external corresponding terminals arranged on a tool, the second connecting terminal 2 and the third connecting terminal 3 are short-circuited to short-circuit PORT2 and PORT3, so that a high voltage output is obtained between PORT4 and PORT1 (the first battery cell group and the second battery cell group are connected in series), and the battery pack externally outputs a voltage of 32 V.

Mode 2:
Through insertion of external corresponding terminals arranged on a tool, the second connecting terminal 2 and the fourth connecting terminal 4 are short-circuited to short-circuit PORT2 and PORT4, and the first connecting terminal 1 and the third connecting terminal 3 are short-circuited to short-circuit PORT1 and PORT3, so that a low voltage output is obtained between PORT4 and PORT1 (the first battery cell group and the second battery cell group are connected in parallel), and the battery pack externally outputs a voltage of 16 V.

In some embodiments, six battery cells may be provided in each battery cell group, and the battery pack can externally output two voltages of 24 V/48 V. Seven battery cells may be provided in each battery cell group, and the battery pack can externally output two voltages of 28 V/56 V. Eight battery cells may be provided in each battery cell group, and the battery pack can externally output two voltages of 32 V/64 V. Nine battery cells may be provided in each battery cell group, and the battery pack can externally output two voltages of 36 V/72 V. Ten battery cells may be provided in each battery cell group, and the battery pack can externally output two voltages of 40 V/80 V, and the like.

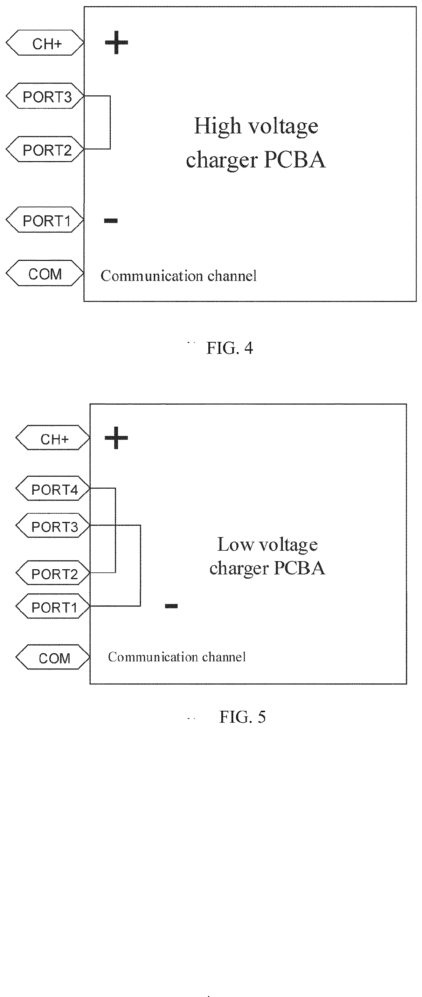

Through this design of the embodiments mentioned above, two voltages can be externally output by connecting matching external corresponding terminals with substantially no increase in cost of the battery pack. It can be understood that in this case, when the battery pack is being charged, a requirement for charging of the battery pack can be met by matching adjustment on terminals of a charger. With a battery pack which can externally output a voltage of 20 V/40 V as an example, the battery pack may be charged by a 20 V matching charger (charging device) or a 40 V matching charger. The charger is provided with external corresponding terminals (for example, six external corresponding terminals) matching connecting terminals respectively, and two external corresponding terminals are configured to be electrically connected to a second positive terminal and a first negative terminal respectively, and electrically connect the second positive terminal to the first negative terminal (by using a preset jumper), with a schematic function diagram of the connection shown in FIG. 4, or two external corresponding terminals are configured to be electrically connected to a first positive terminal and a second positive terminal respectively, and electrically connect the first positive terminal to the second positive terminal, and two external corresponding terminals are configured to be electrically connected to a first negative terminal and a second negative terminal respectively, and electrically connect the first negative terminal to the second negative terminal, with a schematic function diagram of the connection shown in FIG. 5. FIG. 4 shows a schematic connection between a high voltage charger and a battery pack, and FIG. 5 shows a schematic connection between a low voltage charger and a battery pack.

This broadens the application range of the battery pack. An example in which a battery pack externally outputs a voltage of 20 V/40 V is taken for description.

A voltage platform of a normal hand-held portable electric tool is substantially 20 V, so that by using a corresponding terminal jumper of a battery mounting portion of the portable electric tool (this design substantially does not increase design costs, and for the connection method, refer to the external corresponding terminals of the charger), the battery pack can operate in mode 2, and an operation time can be further prolonged by connecting two groups of battery cells in parallel (equivalent to configuring two battery packs).

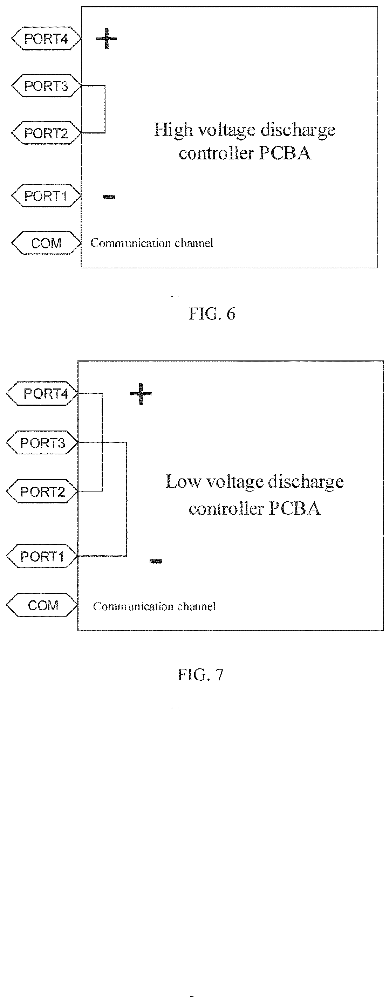

If the battery pack is applied to a tool with a high-voltage platform (such as a cutting circular saw and a DIY hammer drill), the battery pack can operate in mode 1 by changing wiring of corresponding terminals of a battery mounting portion on the tool (this design substantially does not increase design costs). In this way, one battery pack can be used for tools with two voltage platforms (schematic function diagrams of the connections are shown in FIG. 6 and FIG. 7. FIG. 6 shows a schematic connection between a high-voltage discharge controller of a tool and a battery pack (two external corresponding terminals of the tool electrically connect PORT2 and PORT3 to short-circuit PORT2 and PORT3). FIG. 7 shows a schematic connection between a low-voltage discharge controller of a tool and a battery pack (two external corresponding terminals of the tool electrically connect PORT2 and PORT4 to short-circuit PORT2 and PORT4, and two external male terminals electrically connect PORT1 and PORT3 to short-circuit PORT1 and PORT3), which substantially covers tools used by users on a daily basis.

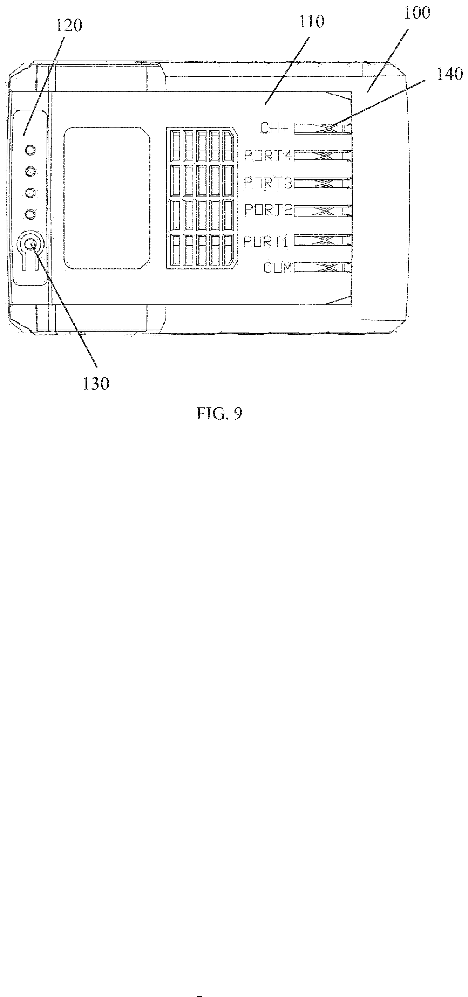

In some embodiments, referring to FIG. 9, a mounting portion 110 is disposed on a side of a housing 100 of the battery pack, a connecting portion 140 having six connecting terminals, CH+, PORT1/PORT2/PORT3/PORT4, and COM (signal terminal) is arranged on a side of the mounting portion 110, and the mounting portion 110 is configured to match and connect to a tool or a charging device (not shown in the figure). After matching and connecting to the tool or the charging device, the connecting portion 140 matches the corresponding portion of the tool or the charging device. In some embodiments, the housing 100 of the battery pack further includes a display portion 120 electrically connected to the control module MCU, which triggers the display portion 120 to display an electric quantity of the first battery cell group and/or the second battery cell group. Preferably, the display portion 120 is a display screen or an indicator. The housing 100 is provided with a button 130. The indicator 120 is turned on by pressing the button 130 on the housing 100, to display the electric quantity of the first battery cell group and/or the second battery cell group.

## Claims

1. A battery pack, comprising:
a housing having a connecting portion (140) configured to match and connect to a tool or a charging device, wherein the connecting portion (140) comprises a first connecting terminal (1), a second connecting terminal (2), a third connecting terminal (3), a fourth connecting terminal (4), a fifth connecting terminal (5), and a sixth connecting terminal (6);
a first battery cell group and a second battery cell group are disposed in the housing (100), and a quantity of battery cells electrically connected in series in the first battery cell group is equal to a quantity of battery cells electrically connected in series in the second battery cell group;
**characterized in that**
the first battery cell group has a first positive terminal (PORT4) and a first negative terminal (PORT3), and the second battery cell group has a second positive terminal (PORT2) and a second negative terminal (PORT1); wherein the first positive terminal (PORT4), the first negative terminal (PORT3), the second positive terminal (PORT2) and the second negative terminal (PORT1) match and correspondingly connect to the second connecting terminal (2) to the fifth connecting terminal (5), respectively;
wherein the sixth connecting terminal (6) functioning as a signal terminal is electrically connected to a control module (MCU) disposed in the housing (100); and
wherein the first connecting terminal (1) functioning as a charging terminal is electrically connected to a first end of a switch (SW), a second end of the switch is electrically connected to the first positive terminal (PORT4), and a third end of the switch is electrically connected to the control module (MCU).

2. The battery pack according to claim 1, wherein a quantity of battery cells in the first battery cell group and the second battery cell group is greater than or equal to 1, respectively.

3. The battery pack according to claim 1, wherein the switch (SW) is an electrically controlled switch.

4. The battery pack according to claim 3, wherein the electrically controlled switch is one of an MOSFET, an IGBT, a relay, a silicon-controlled rectifier, a transistor, or a thyristor.

5. The battery pack according to claim 1, wherein the connecting portion (140) is integrally formed with a part of the housing (100).

6. The battery pack according to claim 1, further comprising a mounting portion (110) disposed on a side of the battery pack, the connecting portion (140) is arranged on a side of the mounting portion (110), and the mounting portion (110) is configured to match and connect to the tool or the charging device.

7. The battery pack according to claim 1, further comprising a display portion (120) disposed on the housing (100), wherein the display portion (120) is electrically connected to the control module (MCU), which is configured to trigger the display portion (120) to display an electric quantity of the first battery cell group and/or the second battery cell group.

8. The battery pack according to claim 7, further comprising a trigger button (130) arranged on the housing (100) and electrically connected to the control module (MCU), wherein the display portion (120) is configured to display the electric quantity of the first battery cell group and/or the second battery cell group when the trigger button (130) is pressed.

9. A charging device for charging the battery pack according to claims 1 to 8, wherein the charging device comprises external corresponding terminals matching the connecting terminals respectively, and two of the external corresponding terminals are configured to be electrically connected to the second positive terminal (PORT2) and the first negative terminal (PORT3) respectively, and electrically connect the second positive terminal (PORT2) to the first negative terminal (PORT3), or
two of the external corresponding terminals are configured to be electrically connected to the first positive terminal (PORT4) and the second positive terminal (PORT2) respectively, and electrically connect the first positive terminal (PORT4) to the second positive terminal (PORT2), the other two of the external corresponding terminals are configured to be electrically connected to the first negative terminal (PORT3) and the second negative terminal (PORT1) respectively, and electrically connect the first negative terminal (PORT3) to the second negative terminal (PORT1).

10. An electric tool carrying the battery pack according to claims 1 to 8, wherein the electric tool is configured to perform discharge control on the battery pack.

## Patentansprüche

1. Batteriepackung, umfassend:
ein Gehäuse mit einem Verbindungsteil (140), das dazu ausgelegt ist, mit einem Werkzeug oder einem Ladegerät zusammenzupassen und eine Verbindung herzustellen, wobei das Verbindungsteil (140) einen ersten Verbindungsanschluss (1), einen zweiten Verbindungsanschluss (2), einen dritten Verbindungsanschluss (3), einen vierten Verbindungsanschluss (4), einen fünften Verbindungsanschluss (5) und einen sechsten Verbindungsanschluss (6) umfasst;
eine erste Batteriezellengruppe und eine zweite Batteriezellengruppe, die in dem Gehäuse (100) angeordnet sind, wobei die Anzahl elektrisch in Reihe geschalteter Batteriezellen in der ersten Batteriezellengruppe gleich der Anzahl elektrisch in Reihe geschalteter Batteriezellen in der zweiten Batteriezellengruppe ist;
**dadurch gekennzeichnet, dass**
die erste Batteriezellengruppe einen ersten Pluspol (PORT4) und einen ersten Minuspol (PORT3) aufweist und die zweite Batteriezellengruppe einen zweiten Pluspol (PORT2) und einen zweiten Minuspol (PORT1) aufweist;
wobei der erste Pluspol (PORT4), der erste Minuspol (PORT3), der zweite Pluspol (PORT2) und der zweite Minuspol (PORT1) mit dem zweiten Verbindungsanschluss (2) bis zum fünften Verbindungsanschluss (5) jeweils korrespondierend zusammepassen und verbunden sind;
wobei der sechste Verbindungsanschluss (6), der als Signalanschluss fungiert, elektrisch mit einem in dem Gehäuse (100) angeordneten Steuermodul (MCU) verbunden ist; und
wobei der erste Verbindungsanschluss (1), der als Ladungsanschluss fungiert, elektrisch mit einem ersten Ende eines Schalters (SW) verbunden ist, ein zweites Ende des Schalters elektrisch mit dem ersten Pluspol (PORT4) verbunden ist und ein drittes Ende des Schalters elektrisch mit dem Steuermodul (MCU) verbunden ist.

2. Batteriepackung nach Patentanspruch 1, wobei die Anzahl der Batteriezellen in der ersten Batteriezellengruppe und der zweiten Batteriezellengruppe jeweils größer oder gleich 1 ist.

3. Batteriepackung nach Patentanspruch 1, wobei der Schalter (SW) ein elektrisch gesteuerter Schalter ist.

4. Batteriepackung nach Patentanspruch 3, wobei der elektrisch gesteuerte Schalter einer aus der Gruppe bestehend aus einem MOSFET, einem IGBT, einem Relais, einem Silizium-gesteuerten Gleichrichter (Thyristor), einem Transistor oder einem Thyristor ist.

5. Batteriepackung nach Patentanspruch 1, wobei das Verbindungsteil (140) mit einem Teil des Gehäuses (100) einstückig ausgebildet ist.

6. Batteriepackung nach Patentanspruch 1, ferner umfassend einen Montageteil (110), der an einer Seite der Batteriepackung angeordnet ist, wobei das Verbindungsteil (140) an einer Seite des Montageteils (110) angeordnet ist und der Montageteil (110) dazu ausgelegt ist, mit dem Werkzeug oder dem Ladegerät zusammenzupassen und eine Verbindung herzustellen.

7. Batteriepackung nach Patentanspruch 1, ferner umfassend einen Anzeigeteil (120), der an dem Gehäuse (100) angeordnet ist, wobei der Anzeigeteil (120) elektrisch mit dem Steuermodul (MCU) verbunden ist, das dazu ausgelegt ist, den Anzeigeteil (120) zu veranlassen, einen Ladezustand der ersten Batteriezellengruppe und/oder der zweiten Batteriezellengruppe anzuzeigen.

8. Batteriepackung nach Patentanspruch 7, ferner umfassend einen Betätigungsknopf (130), der an dem Gehäuse (100) angeordnet und elektrisch mit dem Steuermodul (MCU) verbunden ist, wobei der Anzeigeteil (120) dazu ausgelegt ist, den Ladezustand der ersten Batteriezellengruppe und/oder der zweiten Batteriezellengruppe anzuzeigen, wenn der Betätigungsknopf (130) gedrückt wird.

9. Ladegerät zum Laden der Batteriepackung nach den Patentansprüchen 1 bis 8, wobei das Ladegerät externe, entsprechende Anschlüsse umfasst, die jeweils mit den Verbindungsanschlüssen zusammenpassen, und wobei zwei der externen entsprechenden Anschlüsse dazu ausgelegt sind, elektrisch mit dem zweiten Pluspol (PORT2) und dem ersten Minuspol (PORT3) verbunden zu werden und den zweiten Pluspol (PORT2) mit dem ersten Minuspol (PORT3) elektrisch zu verbinden, oder zwei der externen entsprechenden Anschlüsse dazu ausgelegt sind, elektrisch mit dem ersten Pluspol (PORT4) und dem zweiten Pluspol (PORT2) verbunden zu werden und den ersten Pluspol (PORT4) mit dem zweiten Pluspol (PORT2) elektrisch zu verbinden, und die anderen zwei der externen entsprechenden Anschlüsse dazu ausgelegt sind, elektrisch mit dem ersten Minuspol (PORT3) und dem zweiten Minuspol (PORT1) verbunden zu werden und den ersten Minuspol (PORT3) mit dem zweiten Minuspol (PORT1) elektrisch zu verbinden.

10. Elektrowerkzeug, das die Batteriepackung nach den Patentansprüchen 1 bis 8 trägt, wobei das Elektrowerkzeug dazu ausgelegt ist, eine Entladesteuerung der Batteriepackung durchzuführen.

## Revendications

1. Un bloc-batterie, comprenant :
un boîtier présentant une partie de connexion (140) conçue pour correspondre et se connecter à un outil ou à un dispositif de charge, dans laquelle la partie de connexion (140) comprend une première borne de connexion (1), une deuxième borne de connexion (2), une troisième borne de connexion (3), une quatrième borne de connexion (4), une cinquième borne de connexion (5), et une sixième borne de connexion (6) ;
un premier groupe de cellules de batterie et un deuxième groupe de cellules de batterie sont disposés dans le boîtier (100), et une quantité de cellules de batterie connectées électriquement en série dans le premier groupe de cellules de batterie est égale à une quantité de cellules de batterie connectées électriquement en série dans le deuxième groupe de cellules de batterie ;
**caractérisé en ce que**
le premier groupe de cellules de batterie a une première borne positive (PORT4) et une première borne négative (PORT3), et le deuxième groupe de cellules de batterie a une deuxième borne positive (PORT2) et une deuxième borne négative (PORT1) ;
dans lequel la première borne positive (PORT4), la première borne négative (PORT3), la deuxième borne positive (PORT2) et la deuxième borne négative (PORT1) correspondent et se connectent respectivement à la deuxième borne de connexion (2) à la cinquième borne de connexion (5) ;
dans lequel la sixième borne de connexion (6) fonctionnant comme borne de signal est connectée électriquement à un module de commande (MCU) disposé dans le boîtier (100) ; et
dans lequel la première borne de connexion (1) fonctionnant comme borne de charge est connectée électriquement à une première extrémité d'un interrupteur (SW), une deuxième extrémité de l'interrupteur est connectée électriquement à la première borne positive (PORT4), et une troisième extrémité de l'interrupteur est connectée électriquement au module de commande (MCU).

2. Le bloc-batterie selon la revendication 1, dans lequel une quantité de cellules de batterie dans le premier groupe de cellules de batterie et le deuxième groupe de cellules de batterie est supérieure ou égale à 1, respectivement.

3. Le bloc-batterie selon la revendication 1, dans lequel l'interrupteur (SW) est un interrupteur commandé électriquement.

4. Le bloc-batterie selon la revendication 3, dans lequel l'interrupteur commandé électriquement est un parmi un MOSFET, un IGBT, un relais, un redresseur commandé au silicium, un transistor, ou un thyristor.

5. Le bloc-batterie selon la revendication 1, dans lequel la partie de connexion (140) est formée intégralement avec une partie du boîtier (100).

6. Le bloc-batterie selon la revendication 1, comprenant en outre une partie de montage (110) disposée sur un côté du bloc-batterie, la partie de connexion (140) est agencée sur un côté de la partie de montage (110), et la partie de montage (110) est conçue pour correspondre et se connecter à l'outil ou au dispositif de charge.

7. Le bloc-batterie selon la revendication 1, comprenant en outre une partie d'affichage (120) disposée sur le boîtier (100), dans lequel la partie d'affichage (120) est connectée électriquement au module de commande (MCU), qui est conçu pour déclencher la partie d'affichage (120) afin d'afficher une quantité d'électricité du premier groupe de cellules de batterie et/ou du deuxième groupe de cellules de batterie.

8. Le bloc-batterie selon la revendication 7, comprenant en outre un bouton de déclenchement (130) agencé sur le boîtier (100) et connecté électriquement au module de commande (MCU), dans lequel la partie d'affichage (120) est conçue pour afficher la quantité d'électricité du premier groupe de cellules de batterie et/ou du deuxième groupe de cellules de batterie lorsque le bouton de déclenchement (130) est pressé.

9. Dispositif de charge pour charger le bloc-batterie selon les revendications 1 à 8, dans lequel
le dispositif de charge comprend des bornes externes correspondantes correspondant respectivement aux bornes de connexion, et
deux des bornes externes correspondantes sont conçues pour être connectées électriquement respectivement à la deuxième borne positive (PORT2) et à la première borne négative (PORT3), et connecter électriquement la deuxième borne positive (PORT2) à la première borne négative (PORT3) ; ou
deux des bornes externes correspondantes sont conçues pour être connectées électriquement respectivement à la première borne positive (PORT4) et à la deuxième borne positive (PORT2), et connecter électriquement la première borne positive (PORT4) à la deuxième borne positive (PORT2) ; et
les deux autres des bornes externes correspondantes sont conçues pour être connectées électriquement respectivement à la première borne négative (PORT3) et à la deuxième borne négative (PORT1), et connecter électriquement la première borne négative (PORT3) à la deuxième borne négative (PORT1).

10. Outil électrique portant le bloc-batterie selon les revendications 1 à 8, dans lequel l'outil électrique est conçu pour effectuer un contrôle de décharge sur le bloc-batterie.
